(19) Europäisches Patentamt

European Patent Office

Office européen des brevets

(11) **EP 1 331 653 A2**

(12) **EUROPEAN PATENT APPLICATION**

(43) Date of publication:
**30.07.2003 Bulletin 2003/31**

(51) Int Cl.7: **H01G 9/20**

(21) Application number: **03290210.8**

(22) Date of filing: **28.01.2003**

(84) Designated Contracting States:
**AT BE BG CH CY CZ DE DK EE ES FI FR GB GR
HU IE IT LI LU MC NL PT SE SI SK TR**
Designated Extension States:
**AL LT LV MK RO**

(30) Priority: **29.01.2002 JP 2002020241
14.11.2002 JP 2002331076**

(71) Applicant: **Nippon Shokubai Co., Ltd.
Osaka-shi, Osaka 541-0043 (JP)**

(72) Inventors:
• **Takahashi, Kohshin
Ishikawa-gun, Ishikawa 920-2165 (JP)**
• **Imoto, Kiyoaki
Kanazawa-shi, Ishikawa 920-0941 (JP)**
• **Nakamura, Junichi
Takatsuki, Osaka 569-0854 (JP)**

(74) Representative: **Hubert, Philippe et al
Cabinet Beau de Loménie
158, rue de l'Université
75340 Paris Cédex 07 (FR)**

(54) **Pigment-sensitized solar cell**

(57)    It is an object of the present invention to provide a dye-sensitized solar cell with high cell performance.

The present invention is related to a dye-sensitized solar cell comprising, as constituent elements, a semiconductor electrode with a sensitizing dye adsorbed thereon, a charge transfer layer and a reference electrode, said reference electrode satisfies the relation b > a, where a (mA) denotes the oxidation-reduction electric current value difference in a negative potential region of not lower than -0.7 V but lower than 0 V and b (mA) denotes the oxidation-reduction electric current value difference measured in a positive potential region of 0 V to 0.7 V, said oxidation-reduction electric current value difference are measured by cyclic voltammetry, with the oxidation-reduction potential of ferrocene as a standard.

**EP 1 331 653 A2**

**Description**

FIELD OF THE INVENTION

The present invention relates to a dye-sensitized solar cell in which a semiconductor electrode having a sensitizing dye is used.

BACKGROUND OF THE INVENTION

Recently, dye-sensitized solar cells having a semiconductor electrode with a dye adsorbed thereon have become a focus of attention. Currently, a Pt (platinum) electrode is employed as the reference electrode in most of such dye-sensitized solar cells as is disclosed in Nature (UK),(1991) vol. 353, p. 737. The principal reason is that when a Pt electrode is used as the reference electrode, the rate of oxidation-reduction, on the Pt electrode, of an electrolyte in a charge-transfer medium is very fast, so that excellent cell performance can be secured. However, the Pt electrode has a drawback that it is expensive.

Therefore, investigations have been made concerning the use of other materials as reference electrodes for the purpose of cost reduction. However, most of the so-far known reference electrodes made of materials other than Pt show slower rates of oxidation-reduction of electrolyte than on the Pt electrode, so that a satisfactory cell performance cannot be secured in many cases. Therefore, there is room for contrivance for realizing dye-sensitized solar cells which can exhibit a high cell performance and are inexpensive.

SUMMARY OF THE INVENTION

In view of the above-mentioned state of the art, it is an object of the present invention to provide a dye-sensitized solar cell with high cell performance.

The present inventors made various investigations concerning dye-sensitized solar cells comprising a semiconductor electrode with a sensitizing dye adsorbed thereon, a charge transfer layer and a reference electrode as constituent elements and, as a result, found that when a novel material differing in characteristics from any of those conventional in the art and satisfying a specific requirement with respect to (1) oxidation-reduction characteristics, (2) roughness factor, (3) constituent material or (4) specific surface area is used, such cells can acquire high-level cell performance. Thus, it was found that (1) when the characteristics of reference electrode is specified as expressed in terms of certain cyclic voltammetry data with the oxidation-reduction potential of ferrocene as a standard, it becomes possible to increase the open circuit photo-voltage and thereby improve the energy conversion efficiency; (2) when the roughness factor of the reference electrode is increased and specified, it becomes possible to increase the substantially effective reference electrode surface area and thus secure a high energy conversion efficiency; and (3) when the reference electrode wholly or partly comprises activated carbon or (4) when the specific surface area of a part or the whole of the constituent material of the reference electrode is specified at an increased size, it becomes possible to increase the energy conversion efficiency and attain excellent cell performance. It was also found that dye-sensitized solar cell can thus be supplied with a reduction in production cost. These findings have now led to completion of the present invention. In the practice of the present invention, it is also possible to appropriately combine the above factors (1) to (4) so that the effects of the present invention can fully be produced.

The present invention thus provides a dye-sensitized solar cell comprising, as constituent elements, a semiconductor electrode with a sensitizing dye adsorbed thereon, a charge transfer layer and a reference electrode, said reference electrode satisfies the relation $b > a$, where $a$ (mA) denotes the oxidation-reduction electric current value difference in a negative potential region of not lower than -0.7 V but lower than 0 V and $b$ (mA) denotes the oxidation-reduction electric current value difference measured in a positive potential region of 0 V to 0.7 V, said oxidation-reduction electric current value difference are measured by cyclic voltammetry with the oxidation-reduction potential of ferrocene as a standard (hereinafter also referred to as "first aspect").

The present invention also provides a dye-sensitized solar cell comprising, as constituent elements, a semiconductor electrode with a sensitizing dye adsorbed thereon, a charge transfer layer and a reference electrode, wherein said reference electrode has a roughness factor of not less than 5,000 (hereinafter also referred to as "second aspect").

DETAILED DESCRIPTION OF THE INVENTION

In the following, the present invention is described in detail.

The present invention provides a dye-sensitized solar cell having high cell performance, and the reference electrode thereof constitutes a characteristic feature of the same.

According to the first aspect of the present invention, there is provided a dye-sensitized solar cell comprising a reference electrode which satisfies the relation $b > a$, where $a$ (mA) denotes the oxidation-reduction current value difference in a negative potential region of not lower than -0.7 V but lower than 0 V and $b$ (mA) denotes the oxidation-reduction current value difference measured in a positive potential region of 0 V to 0.7 V measured by cyclic voltammetry, with the oxidation-reduction potential of ferrocene as a standard. When such reference electrode is used, it is possible, in particular, to increase the open circuit photo-voltage of the dye-sensitized solar cell.

The energy conversion efficiency $\eta$ (%) representing the cell performance of the above dye-sensitized solar cell can be calculated as follows:

$$\eta = 100 \times Voc \times Jsc \times FF/I \qquad (1)$$

where Voc (V) is the open circuit photo-voltage,
Jsc (mA/cm$^2$) is the short circuit photo-current density,
FF is the fill factor and
I (mW/cm$^2$) is the incident light intensity.

Therefore, for improving the energy conversion efficiency of a dye-sensitized solar cell, it is necessary to increase one or more of the open circuit photo-voltage, short circuit photo-current density and fill factor. In accordance with the first aspect of the present invention, the open circuit photo-voltage, among others, is increased so that the energy conversion efficiency of the dye-sensitized solar cell may be improved.

The "oxidation-reduction current value difference" so referred to herein is determined, by any of the following procedures (I) to (IV), from the negative side; negative potential region from -0.7 V up to just below 0 V, and positive side; positive potential region from 0 V to 0.7 V, of a cyclic voltammogram [current (current density)-potential curve] obtained by CV measurement under the conditions to be mentioned later herein.

(I) In cases where oxidation-reduction peaks (an oxidation peak and a reduction peak in pair) occur on the negative or positive side of a cyclic voltammogram, the oxidation-reduction potential (mean value of the oxidation peak potential and reduction peak potential) found on the negative side is regarded as the "oxidation-reduction peak in the negative potential region" and that found on the positive side as the "oxidation-reduction peak in the positive potential region". The absolute value of the difference between the oxidation peak current value and reduction peak current value as determined from the respective oxidation-reduction peaks is taken as the "oxidation-reduction current value difference".

(II) In cases where only an oxidation peak or reduction peak occurs on the negative side and/or positive side of a cyclic voltammogram, the absolute value of the difference between the oxidation current value and reduction current value is determined at the potential corresponding to the peak and that absolute value is taken as the "oxidation-reduction current value difference".

(III) In cases where neither oxidation peak nor reduction peak is found on the negative side or positive side of a cyclic voltammogram, the "oxidation-reduction current value difference" is regarded as zero.

(IV) In cases where two or more oxidation-reduction current value differences are detectable on the negative side and/or positive side of a cyclic voltammogram, the greatest value(s) is(are) regarded as the oxidation-reduction current value difference(s) on the negative side and/or positive side.

The above CV measurement is carried out in the following manner.

Acetonitrile dehydrated with calcium hydride and then rectified is used as the solvent for a reference electrode, salt bridge and measurement. Ag/AgNO$_3$ in acetonitrile (0.1 mol/L) is used as the reference electrode. A reference electrode of the dye-sensitized solar cell of the present invention is used as a working electrode, and a Pt electrode as a reference electrode for the measurement. The working electrode has a surface area of 0.2 cm$^2$. A cell containing an electrolyte (an acetonitrile solution containing 0.001 mol/L of iodine, 0.001 mol/L of lithium iodide and 0.1 mol/L of tetraethylammonium perchlorate) is prepared. The working electrode and reference electrode for measurement are placed in this cell. This cell is connected to the reference electrode via a salt bridge (an acetonitrile solution containing 0.1 mol/L of tetraethylammonium perchlorate). The reference electrode, working electrode and reference electrode for measurement are connected to a potentiostat. A function generator is connected to the potentiostat. Suited for use are preferably a Hokuto Denko model "HA-151" potentiostat and a Hokuto Denko model "HB-111" function generator.

The solution in the cell is degassed using N$_2$ gas for 30 minutes prior to the CV measurement. The potential sweep rate was set at 50 mV/sec using the function generator, and the working electrode-reference electrode potential (-0.7 to 0.7 V) is scanned at said potential sweep rate using the potentiostat. The current and potential data measured on the reference electrode during this potential scanning are fed into the potentiostat for drawing a graph using an XY plotter or the like, whereby a cyclic voltammogram is yielded.

In the above CV measurement, the oxidation-reduction potential of ferrocene is taken as a standard. Thus, the oxidation-reduction potential (mean of the oxidation peak potential and reduction peak potential) of ferrocene as measured under the same conditions as mentioned above except that a glassy carbon electrode is used instead of the working electrode in the above CV measurement and that an acetonitrile solution containing 0.001 mol/L of ferrocene and 0.1 mol/L of tetraethylammonium perchlorate is used as the electrolyte is taken as the reference potential "0 V" in the above CV measurement.

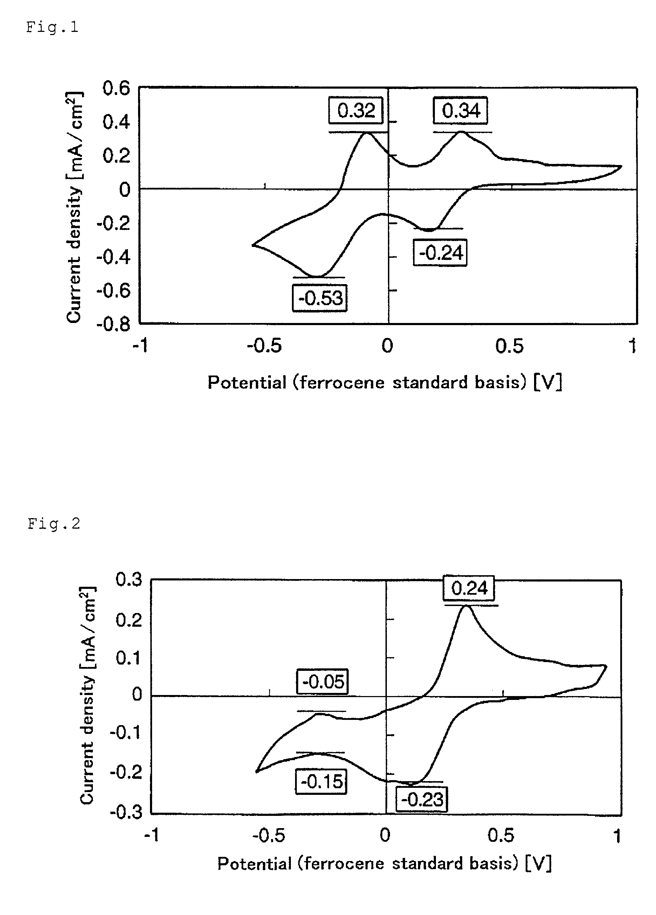

Typical examples of the cyclic voltammogram obtainable in the above manner are shown in Fig. 1 and Fig. 2. The one shown in Fig. 1 was measured using, as the working electrode, a Pt electrode which is employed as a reference electrode in the prior art dye-sensitized solar cell, and the one shown in Fig. 2 was measured using a reference electrode according to the present invention as the working electrode.

In the cyclic voltammogram shown in Fig. 1, an oxidation-due peak and a reduction-due peak are observable on each of the positive and negative sides.

When, as in the above case, both of an oxidation peak and a reduction peak are observed on each of the positive and negative sides, the oxidation-reduction current value difference is determined according to the above-mentioned procedure (I). In the cyclic voltammogram shown in Fig. 1, the ordinate denotes a current density. Therefore, the current value is calculated by multiplying the current density determined from the cyclic voltammogram by the electrode surface area (0.2 $cm^2$). Thus, the oxidation-reduction current value difference a is $|0.32 \times 0.2 - (-0.53 \times 0.2)| = 0.17$ (mA). The oxidation-reduction current value difference b is $|0.34 \times 0.2 - (-0.24 \times 0.2)| = 0.116$ (mA).

On the other hand, in the cyclic voltammogram shown in Fig. 2, an oxidation-due peak and a reduction-due peak are observed on the positive side, while an oxidation-due peak alone is observed on the negative side.

When, as in this case, an oxidation peak or a reduction peak alone is observed on the negative side, the oxidation-reduction current value difference is determined according to the above-mentioned procedure (II). Thus, the oxidation-reduction current value difference a is $|-0.05 \times 0.2 - (-0.15 \times 0.2)| = 0.02$ (mA). On the other hand, the oxidation-reduction current value difference b is determined according to the above procedure (I), as in the case of the cyclic voltammogram shown in Fig. 1, thus $|0.24 \times 0.2 - (-0.23 \times 0.2)| = 0.094$ (mA).

Here, the oxidation-reduction current value differences a and b obtained from the cyclic voltammogram shown in Fig. 1 are in the relation "b < a", hence the requirement imposed herein is not satisfied. On the other hand, the relation between the oxidation-reduction current value differences a and b obtained from the cyclic voltammogram shown in Fig. 2 is "b > a", hence the requirement imposed herein is satisfied.

In the above procedure (I), whether the oxidation-reduction current value difference is on the positive side or on the negative side is judged according to the sides on which the oxidation-reduction potentials corresponding to the oxidation-reduction peaks occur. For example, when a reduction peak potential occurs on the negative side and an oxidation peak potential on the positive side, the oxidation-reduction potential is determined. When the oxidation-reduction potential is on the positive side, the oxidation-reduction current value difference is regarded as occurring on the positive side (namely, oxidation-reduction current value difference b). When, conversely, the oxidation-reduction potential is on the negative side, the oxidation-reduction current value difference is regarded as occurring on the negative side (namely, oxidation-reduction current value difference a).

The electrode reaction occurring on the reference electrode of a dye-sensitized solar cell is the reaction between the electrolyte migrating in the charge transfer layer and the reference electrode. On the conventional Pt electrode, the main part of this electrode reaction is supposed to be the oxidation-reduction reaction observed on the negative side (on the above-mentioned ferrocene standard basis) in the above CV measurement. Although it is not clear, the reason is probably that the electrolyte is involved in the oxidation-reduction reaction in different ways on the positive side and on the negative side in the above CV measurement. Conceivably, this difference leads to an increased open circuit photo-voltage in the dye-sensitized solar cell. As regards the half-wave potential itself, the oxidation-reduction potentials show shifting to the positive side as compared with the Pt electrode. Presumably, this is also a reason for the improvement in open circuit photo-voltage. When, for example, an acetonitrile solution containing 0.0045 mol/L of iodine, 0.0005 mol/L of lithium iodide and 0.1 mol/L of tetraethylammonium perchlorate is used as the electrolyte and the Pt electrode described in Comparative Example 1 (given later herein) as the reference electrode, the half-wave potentials (oxidation-reduction potentials observed on the negative side (on the above-mentioned ferrocene standard basis) in Fig. 1) for $I^-/I_3^-$ are -0.15 V and +0.24 V whereas, when the carbonaceous material prepared in Example 2 is used, they are -0.09 V and + 0.31 V.

In the practice of the present invention, a material causing shifting of the half-wave potential to the positive side in the above CV measurement as compared with Pt is preferably used as the reference electrode. Thus, a dye-sensitized solar cell, the reference electrode of which comprises, as a constituent material, a material showing a formal potential on the positive side as compared with Pt, constitutes one of preferred embodiments of the present invention.

Thus, in accordance with the first aspect of the present invention, an attempt is made to improve the cell performance of the dye-sensitized solar cell by employing a reference electrode on which a specific electrode reaction occurs.

As regards the relation between the oxidation-reduction current value differences a and b, the condition $b \geqq 2a$ is more preferred and the condition $b \geqq 4a$ is still more preferred.

In accordance with the second aspect of the present invention, there is provided a dye-sensitized solar cell in which a reference electrode having a roughness factor of not less than 5,000 is used. When the reference electrode has a roughness factor of not less than 5,000, the reference electrode area capable of substantially acting is large and a high level of energy conversion efficiency can be secured. More preferably, the roughness factor of the reference electrode is not less than 10,000, still more preferably not less than 100,000.

The "roughness factor" so referred to herein means the value obtained by diving the specific surface area of the reference electrode as measured by the BET adsorption method (gas to be adsorbed: $N_2$) using an apparatus manufactured by Delsorp corp., for instance, by the sum total of the areas of the respective surfaces of the reference electrode as projected from just above.

Further, it is preferred that the dye-sensitized solar cell of the present invention should have both the features of the first and second aspects mentioned above. Thus, as regards the above-mentioned reference electrode, it is preferred that the above-defined oxidation-reduction current value differences a (mA) and b (mA) determined by CV measurements with the oxidation-reduction potential of ferrocene as a standard satisfy the relation b > a and, at the same time, the roughness factor be not less than 5,000. By using such reference electrode, it becomes possible to secure higher levels of cell performance.

In the following, the respective constituent elements of the dye-sensitized solar cell of the present invention are described in detail.

[Reference electrode]

The reference electrode of the dye-sensitized solar cell of the present invention is not particularly restricted with respect to the material and the like thereof provided that the relation "b > a" is obtained by the above-mentioned CV measurement or the roughness factor is not less than the above-specified value. For example, a reference electrode obtained by such a technique as bonding particles of a conductive substance onto a conductive substrate using a binder or sticking a sheet made of a (porous) conductive substance to a conductive substrate can be employed. In addition, a porous conductive sheet, such as an foamed metal sheet, for instance, may also be used.

Suited for use as the above-mentioned conductive substance are, for example, various metals. A carbonaceous material is preferred, however, in view of its inexpensiveness and the possibility of making a reference electrode satisfying both the above relation "b > a" in CV measurements and the above roughness factor requirement. The dye-sensitized solar cell, when it comprises a carbonaceous material as a constituent material of the reference electrode, constitutes one of the preferred embodiments of the present invention.

For obtaining a reference electrode having a roughness factor value not lower than the above specified value, in particular, it is preferred that the carbonaceous material be porous. Thus, activated carbon may be mentioned as a specific example of the carbonaceous material preferred as a reference electrode material.

The present invention further relates to a dye-sensitized solar cell comprising as constituent elements, a semiconductor electrode with a sensitizing dye adsorbed thereon, a charge transfer layer and a reference electrode, wherein said reference electrode comprises activated carbon as a constituent material thereof. Such dye-sensitized solar cell also can exhibit good cell performance.

The above-mentioned activated carbon includes those species known in the art. Suited are activated carbon species obtained, for example, by the method comprising subjecting a wood material, such as coconut shells or sawdust, or an organic substance having a high carbon content, such as brown coal, peat, a plastic or petroleum pitch, to activation treatment (e.g. treatment with zinc chloride or phosphoric acid), followed by carbonization. The method and raw material for activated carbon production are not limited to those mentioned above but the activated carbon may be one based on any of other appropriate raw materials and/or production methods.

The activated carbon to be used in the reference electrode is preferably low in content of impurities including metals, such as iron and alkaline metals, and compounds of such metals. When the content of iron or iron compounds, for instance, is high, the impurities act as charge recombination centers on the semiconductor electrode surface, which is to be mentioned later herein.

Therefore, the activated carbon is preferably one obtained via a step of removing impurities by washing, for instance. In some instances, however, even when a impurity removing step is provided, the impurities in activated carbon cannot be removed to a satisfactory extent. Therefore, a synthetic resin (organic resin) is preferably employed as the material of activated carbon. It is relatively easy to control the content of impurity compounds, among others, in a synthetic resin. As for the synthetic resin species, almost all synthetic resins (organic resins) can be used as raw materials. From the easiness of activated carbon production viewpoint, however, non-heat-melting synthetic resins are more preferred. As typical examples of such non-heat-melting synthetic resins, there may be mentioned phenol resins.

The present invention further relates to a dye-sensitized solar cell comprising, as constituent elements, a semiconductor electrode with a sensitizing dye adsorbed thereon, a charge transfer layer and a reference electrode, wherein said reference electrode comprises, as a constituent material thereof, a material having a specific surface area of not less than 500 $m^2/g$. Thus, from the viewpoint of increasing the cell performance of the dye-sensitized solar cell, it is desirable that the reference electrode have a higher level of porosity.

More preferably, the specific surface area is not less than 1,000 $m^2/g$. As for the bulk density of the reference electrode, it is preferably not less than 0.1 g/$cm^3$, more preferably not less than 0.2 g/$cm^3$. The use of a reference electrode having such specific surface area and bulk density is preferred, by which it becomes easy to increase the roughness factor of the reference electrode to the above-specified value or above.

The reference electrode specific surface area mentioned above refers to the value determined by the BET adsorption method (gas to be adsorbed: $N_2$) using a apparatus manufactured by Delsorp, for instance. The bulk density of the reference electrode is the value determined by packing activated carbon in a plastic cylinder and making measurements under a pressure of 4 t/cm$^2$.

Taking, as an example, the case in which activated carbon is used as the above-mentioned conductive material, the constitution of the reference electrode is now explained. As mentioned above, the conductive substance usable in the reference electrode in the practice of the present invention is not limited to activated carbon.

The above reference electrode is obtained, for example, by binding activated carbon onto a substrate by means of a binder. In this case, the activated carbon layer formed on the substrate serves as the conductive layer. The dye-sensitized solar cell in which the reference electrode further comprises a binder as a constituent material thereof, as mentioned above, constitutes one of the preferred embodiments of the present invention.

The substrate species is not particularly restricted. However, in cases where a conductive substance relatively low in conductivity, such as activated carbon, is used, it is preferred that the substrate itself has electric conductivity so that it may be in contact with activated carbon bound thereto and the electric current may be taken out accordingly.

Suited as such conductive substrates are various metal sheets, such as Pt, Au, Ag, Cu, Al and stainless steel sheets, and conductive metal oxides such as ITO (In-Sn composited oxide) and FTO (fluorine-doped tin oxide). Those substrates made by forming a layer of a metal, such as Pt, Au, Ag, Cu or Al, or a conductive metal oxide, such as ITO or FTO, on the surface of a sheet of glass or of any of various plastics by vapor deposition, for instance may also be used. Furthermore, metal leads, which are to be mentioned later herein relative to the conductive substrate of the semiconductor electrode, may also be disposed on the conductive substrate for the purpose of conductivity improvement.

When the dye-sensitized solar cell is irradiated with light from the reference electrode side, at least the reference electrode must be substantially transparent.

The term "substantially transparent" as used herein means that the transmittance of the light at the wavelength 500 nm as transmitted through the object (here, the reference electrode) should be not less than 50%. More preferably, the transmittance is not less than 80%.

Therefore, when the dye-sensitized solar cell is to be irradiated with light from the reference electrode side, the substrate for the reference electrode should be selected so that the reference electrode as a whole can secure such transmittance as mentioned above.

A sheet-like form of activated carbon as obtained from a synthetic resin or the like molded in the form of a sheet can also be used as the reference electrode. However, a reference electrode prepared by binding a powder form of activated carbon onto a reference electrode substrate using a binder is less expensive. Also usable is a reference electrode prepared by binding activated carbon onto a composite sheet, such as "Gore-Tex" (trademark), a product of Japan Gore-Tex, although it is more expensive.

The thickness of the substrate mentioned above is not particularly restricted but generally is about 100 to about 50,000 μm. In cases where a metal layer or conductive metal oxide layer is formed on a glass sheet or plastic film, the thickness of such layer is not particularly restricted but generally is about 0.001 to about 50 μm.

Suited for use as the above-mentioned binder are carboxymethylcellulose, hydroxyethylcellulose, hydroxypropylcellulose and polyvinylidene fluoride. These may be used singly or two or more of them may be used in combination.

A suitable method for producing the above reference electrode comprises mixing activated carbon with the binder, dispersing the said mixture in pure water, applying the resulting slurry to the reference electrode substrate, and drying the same.

The activated carbon-binder mixing ratio is preferably such that activated carbon accounts for 50 to 95% by mass, more preferably 70 to 90% by mass, per 100% by mass of the sum of the activated carbon and binder (for example, activated carbon 80% by mass and binder 20% by mass). When such mixing ratio is employed, the reference electrode can have good performance and durability.

The concentration of the above slurry is preferably such that 10 to 50 parts by mass, more preferably 20 to 40 parts by mass, of the activated carbon-binder mixture is used per 100 parts by weight of pure water. When the slurry is used in such concentration, the activated carbon layer (conductive layer) can have a desired thickness, which is to be mentioned later herein, and the reference electrode obtained can show high performance.

A Suitable method of applying the above slurry to the reference electrode substrate is such a known method as the method mentioned later herein as an example of the method of applying a dispersion solution of minute semiconductor particles to a conductive substrate for semiconductor electrode manufacture.

The method of drying the above slurry may be any of those known in the art. The drying temperature and drying time may be selected arbitrarily provided that the reference electrode characteristics will not be impaired. Generally, the drying temperature is 100 to 200°C, and the drying time is 10 to 60 minutes.

In the above-mentioned reference electrode, the activated carbon layer (conductive layer) formed on the reference electrode substrate preferably has a thickness, after drying, of 0.1 to 500 μm, more preferably 10

to 200 μm. When the thickness of the activated carbon layer is within the above range, it becomes possible to manufacture dye-sensitized solar cells having good cell performance.

An electric conductivity providing agent may further be added to the activated carbon-binder mixture for the purpose of conductivity improvement. The dye-sensitized solar cell in which the reference electrode further contains an electric conductivity providing agent as a constituent material thereof constitutes one of the preferred embodiments of the present invention.

Specific examples of the electric conductivity providing agent are conductive inorganic materials such as various metals each in a minute particle form; carbon black, conductive organic materials such as conductive polymers; and composite materials resulting from combination thereof. These conductivity providing agents are used preferably at an addition level of 5 to 30 parts by mass, more preferably 10 to 20 parts by mass, per 100 parts by mass of the sum total of the activated carbon and binder.

[Semiconductor electrode]

In the dye-sensitized solar cell of the present invention, the semiconductor electrode (photoelectrode) has a sensitizing dye adsorbed thereon and may be any of those semiconductor electrodes known in the art and used in the conventional dye-sensitized solar cells. More specifically, the semiconductor electrode comprises a porous semiconductor layer formed on a conductive substrate and a sensitizing dye adsorbed on pore of the semiconductor layer.

Suited for use as the semiconductor to be applied to the above semiconductor electrode are simple substance semiconductors such as Si and Ge, III-V type compound semiconductors, metal chalcogenides, and compound having a perovskite structure.

The metal chalcogenides include metal-chalcogen compounds, namely oxides, sulfides, selenides, and tellurides, among others, of metals. More specifically, the following are suitable species: oxides of Ti, V, Fe, Zn, Sr, Y, Zr, Nb, In, Sn, La, Ce, Hf, Ta, and W; sulfides of Zn, Cd, Ag, Sb, Pb, and Bi; selenides of Cd and Pd; and telluride of Cd.

Preferred as the compounds having a perovskite structure are strontium titanate, calcium titanate, barium titanate, sodium titanate, and potassium niobate.

In addition, Ga, In, Cd and like phosphides; CaAs; Cu-In selenide; Cu-In sulfide and like compound semiconductors are also suited for use.

Among the semiconductors mentioned above, the following are preferably used in the semiconductor electrode according to the present invention: Si, $TiO_2$, $Fe_2O_3$, ZnO, $Nb_2O_5$, $WO_3$, ZnS, CdS, PbS, $Bi_2S_2$, $CuInS_2$, CdSe, $CuInSe_2$, CdTe, GaP, InP, and GaAs. $TiO_2$ is particularly preferred among others.

The above-mentioned $TiO_2$ includes two crystal structures, namely an anatase and rutile types. The crystal structure of $TiO_2$ to be employed in the above-mentioned semiconductor electrode may be of either type. The anatase type is preferred, however, since the anatase type is more resistant to damages from exposure to ultraviolet radiation than the rutile type. Therefore, in the case of a mixture of anatase-type and rutile-type $TiO_2$, a higher anatase type content (e.g. 70% or higher) is preferred.

The above semiconductor may be either monocrystalline or polycrystalline. When the semiconductor is monocrystalline, the cell performance (energy conversion efficiency) becomes higher. On the other hand, polycrystalline semiconductors are advantageous from the cost viewpoint. The above semiconductor is in the form of minute particles, and the average particle size is generally 1 to 300 nm.

When the dye-sensitized solar cell of the present invention is to be irradiated with light from the semiconductor electrode side, at least the conductive substrate to be used in the semiconductor electrode must be "substantially transparent". Of course, both of the conductive substrate to be used in the semiconductor electrode and the above-mentioned reference electrode may be substantially transparent and, in this case, the dye-sensitized solar cell is capable of photo-electric conversion upon light exposure either from the semiconductor electrode side or from the reference electrode side.

The above-mentioned substantially transparent conductive substrate is, for example, a glass sheet or plastic film with a conductive layer formed thereon. Suited as the conductive layer-forming material are thin films of metals, such as Al, Cu, Rh, Ag, In, Pt, and Au; thin films of conductive metal oxides, such as ITO and FTO; and thin carbon films. The thickness of the conductive layer is not particularly restricted provided that the above-mentioned "substantially transparent" state can be secured. Generally, however, it is about 0.001 to about 100 μm.

The above conductive layer can be formed on the glass or plastic film surface by any of such known methods as vapor deposition and sputtering.

Suited for use as the material of the plastic film to be used in preparing the conductive substrate are polyethylene terephthalate, polyethylene naphthalate, polycarbonates, polyphenylene sulfide, polyarylates, polysulfones, polyestersulfones, polyetherimides, syndiotactic polystyrene, tetraacetylcellulose, cyclic polyolefins, and brominated phenoxys.

Those conductive substrates prepared by forming a thin film of a metal oxide such as ITO or FTO on a glass sheet or a plastic film constituted of any of the materials listed hereinabove are preferred among others.

The resistance of the above conductive substrate can be reduced by disposing metal leads on the above substrate within the limits within which the above-mentioned "substantial transparency" can be secured. Preferably used as the material of the metal leads are Al, Ni, Cu, Ag, Pt, and Au.

Preferably, the surface resistance of the above conductive substrate should be as low as possible and, recommendably, it should be not more than 100 $\Omega$/cm$^2$, more preferably not more than 10 $\Omega$/cm$^2$.

The above metal leads can be formed by the technique which comprises forming a layer of one of the metals mentioned above on the surface of a glass sheet or plastic film by vapor deposition or sputtering and forming, thereon, a conductive layer such as a thin film of such a metal oxide as mentioned above, for example ITO or FTO. Also employable is the technique comprising providing metal leads on a conductive layer formed on the glass or plastic film surface.

In forming a semiconductor layer on the conductive layer, any of the methods known in the art can be employed. For example, the method comprising applying a dispersion solution of minute semiconductor particles onto the conductive substrate is preferred.

The method for producing the above dispersion solution may be any of the methods known in the art, for example the well-known sol-gel method, the method comprising carrying out the semiconductor production in a solvent and using the resulting semiconductor dispersion solution as such and, further, the method comprising dispersing the semiconductor in a dispersion medium following or while comminuting the semiconductor in a mill or mortar.

Water or any of various organic solvents may be used as the dispersion medium in preparing the above dispersion solution. Suitable organic solvents are methanol, ethanol, isopropanol and other alcohol solvents; acetone, acetonitrile, dichloromethane, and ethyl acetate. If necessary, one or more of various dispersing agents and the like, such as detergent, acids, chelating agents, and polymers, may be added to the above dispersion solution.

The viscosity of the above dispersion solution is not particularly restricted but may appropriately be selected according to the method of application (to be mentioned below) employed in applying the above dispersion onto the conductive substrate.

The method of applying the above dispersion solution onto the conductive substrate may be any of the methods known in the art. Suitable are the roller method, dipping method, doctor blade method, air knife method, slide hopper method, extrusion method, curtain method, wire bar method, spinning method, and spraying method. The offset, gravure, relief, intaglio, rubber plate, screen and like printing methods are also suitable.

After application of the above dispersion solution onto the conductive substrate, heat treatment is carried out to form a semiconductor layer. The heat treatment temperature is generally 150 to 800°C, preferably within the range of 300 to 600°C, and the temperature is selected so that the characteristics of the material employed as the conductive substrate may not be impaired. Recommendably, the heat treatment time is generally about 15 to 240 minutes.

By carrying out chemical plating using an aqueous solution of titanium tetrachloride or electrochemical plating using an aqueous solution of titanium trichloride after the above heat treatment, it is possible to increase the surface area of semiconductor particles in the semiconductor layer or increase the purity in the vicinity of semiconductor particles to thereby improve the efficiency of electron injection from the sensitizing dye into the semiconductor particles.

The thus-formed semiconductor layer generally has a thickness of 0.1 to 30 $\mu$m. When the thickness of the semiconductor layer is within such range, the amount of the sensitizing dye adsorbed can be made enough and, at the same time, the loss due to increases in diffusion length of generated electrons can be prevented. Furthermore, for enabling the adsorption of the sensitizing dye in sufficient amounts, the roughness factor of the semiconductor layer is preferably not less than 500, more preferably not less than 1,000.

In the practice of the present invention, those dyes known in the art and showing light-absorbing characteristics in the visible and ultraviolet light regions can be employed as the sensitizing dye. The above sensitizing dyes preferably have an interlocking group or groups, such as a carboxyl, hydroxyl, alkoxyl, hydroxyalkyl, ester, sulfonic acid, phosphonyl, and mercapto group or groups. These interlocking groups provide electric bonding facilitating the electron transfer between the sensitizing dye-semiconductor conduction bands.

Suited for use as the above sensitizing dye are ruthenium bipyridine dyes, cyanine dyes, merocyanine dyes, phthalocyanine dyes, naphthalocyanine dyes, azo dyes, quinone dyes, quinonimine dyes, quinacridone dyes, squarylium dyes, triphenylmethane dyes, xanthene dyes, porphyrin dyes, perylene dyes, and indigo dyes. These sensitizing dyes may be used singly or two or more of them may be used in combination. In particular, the combined use of two or more sensitizing dyes differing in absorption light wavelength is recommended since the light wavelength range utilizable for photo-electric conversion can be increased thereby.

In causing the above sensitizing dye to be adsorbed on the semiconductor electrode, any of the methods known in the art can be employed. Suitable are, for example, the method comprising preparing a solution of the sensitizing dye using a solvent and dipping the semiconductor electrode in the solution, and the method comprising applying that solution to the semiconductor electrode. As for the method of application, the known methods, namely the methods mentioned hereinabove as examples of the method of applying the semiconductor dispersion solution onto the conductive substrate in preparing the semiconductor electrode, can be employed.

Usable as the solvent in preparing the above sensitizing dye solution are alcohols such as methanol, ethanol, tert-butanol and benzyl alcohol; ketones such as acetone, 2-butanone and cyclohexanone; ethers such as diethyl ether and tetrahydrofuran; nitrile compounds such as acetonitrile, propionitrile and 3-methoxypropionitrile; hydrocarbons such as hexane, petroleum ether, benzene and toluene; halogenated hydrocarbons such as dichloromethane, dichloroethane, chloroform and chlorobenzene; esters such as ethyl acetate and butyl acetate; carbonate esters such as diethyl carbonate, ethylene carbonate and propion carbonate; amides such as N,N-dimethylformamide, N,N-dimethylacetamide; nitromethane; N-methylpyrrolidone; 1,3-dimethylimidazolidinone; 3-methyloxazolidinone, and like known ones. These solvents may be used singly or two or more of them may be used in admixture. The preferred sensitizing dye concentration in the sensitizing dye solution may vary depending on the sensitizing dye species and solvent species but generally is within the range of 1.0 $\times 10^{-4}$ to $4.0 \times 10^{-4}$ mol/L, preferably $2.0 \times 10^{-4}$ to $3.0 \times 10^{-4}$ mol/L.

When the above-mentioned dipping method is employed, the dipping time and dipping temperature can appropriately be selected according to the sensitizing dye and solvent species. In the application method, too, the application temperature and the solvent drying temperature can adequately be selected according to the sensitizing dye and solvent species.

When the semiconductor electrode is subjected to heat treatment at about 100 to 400°C prior to the above adsorption treatment, the level of adsorption of the sensitizing dye can be increased. In this case, it is preferred, for preventing moisture absorption by the semiconductor electrode, that the heat treatment is directly followed by the adsorption treatment without allowing the return to ordinary temperature.

That portion of the sensitizing dye which remains unadsorbed on the semiconductor electrode after the above dipping or after the application and drying may produce a bad influence on the performance of the dye-sensitized solar cell, so that it is preferably removed by washing using one of various solvents mentioned hereinabove as examples of the solvent for sensitizing dye solution preparation.

The level of adsorption of the sensitizing dye on the above semiconductor electrode is preferably not less than $1 \times 10^{-8}$ mol/cm$^2$ and, at such adsorption level, a sufficient sensitizing effect can be secured. More preferably, the level of adsorption of the sensitizing dye is $5 \times 10^{-8}$ mol/cm$^2$.

For reducing the interaction (e.g. association) between sensitizing dye molecules, a colorless compound may be adsorbed on the semiconductor electrode together with the sensitizing dye. Suitable as such compound are carboxyl group-containing steroid compounds, such as ketodeoxycholic acid. An ultraviolet absorber and/or the like may further be used in combination.

Furthermore, for removing the excess sensitizing dye, it is also preferable to treat the semiconductor layer surface of the semiconductor electrode using an amine after the above adsorption treatment. Suitable as such amine are pyridine, 4-tert-butylpyridine, and polyvinylpyridine. These may be used as such when they occur as liquids, or in the form of solutions in an organic solvent.

[Charge transfer layer]

The charge transfer layer to be used in the dye-sensitized solar cell of the present invention may be any of those used in the dye-sensitized solar cells known in the art.

The roll of the charge transfer layer is to supply electrons to the semiconductor electrode. As a typical charge transfer layer, there may be mentioned an electrolysis solution. This electrolysis solution is constituted of an electrolyte, a solvent and an additive. A combination of an oxidant and a reductant (hereinafter sometimes referred to as "oxidation-reduction pair") is used as the electrolyte. Generally used as such electrolyte are the combination of iodine ($I_2$) and an iodide, and the combination of bromine ($Br_2$) and a bromide.

Suited for use as the iodide to be combined with the above-mentioned iodine are metal iodides such as $CaI_2$, LiI, NaI, KI, and CsI; and iodide salts of quaternary ammonium compounds, such as pyridinium iodide, imidazolium iodide, and tetraalkylammonium iodides.

Suited for use as the bromide to be combined with the above-mentioned bromine are metal bromides such as $CaBr_2$, LiBr, NaBr, KBr, and CsBr; and bromide salts of quaternary ammonium compounds, such as pyridinium bromide and tetraalkylammonium bromides.

Also applicable, in addition to the above-mentioned electrolytes, are such electrolytes as metal complexes such as ferrocyanate-ferricyanate and ferrocene-ferrocenium ion; sulfur compounds such as sodium polysulfide and alkylthiol-alkyl disulfides; viologen dyes; chlorine-chloride; hydroquinone-quinone; and succinic acid-fumaric acid. Furthermore, combinations of ion-forming compounds may also be used, for example thallium(I) ion-thallium(III) ion, mercury(I) ion-mercury(II) ion, ruthenium(II) ion-ruthenium(III) ion, copper (I) ion-copper(II) ion, iron(II) ion-iron(III) ion, vanadium (II) ion-vanadium(III) ion, and permanganate ion-manganate ion. Two or more of the electrolytes specifically mentioned above may be used in admixture.

It has been confirmed that when the electrolysis solution contains iodine and the iodide ion, especially excellent cell performance can be secured in the practice of the present invention. Therefore, the combination of iodine and one of the iodides mentioned above is preferably employed as the electrolyte.

The electrolyte concentration in the above electrolysis solution is generally 0.01 to 1 mol/L, more generally 0.2 to 0.5 mol/L. When iodine is used, the iodine concentration is preferably 10 to 50 mmol/l.

The solvent to be used in the above electrolysis solution is preferably one capable of sufficiently dissolving the electrolyte and, at the same time, having a low viscosity and good ionic conductivity. Suitable as the solvent are ethers, such as dioxane, diethyl ether, 1,2-dimethoxyethane, ethylene glycol dialkyl ethers, propylene glycol dialkyl ethers, polyethylene glycol dialkyl ethers, polypropylene glycol dialkyl ethers, tetrahydrofuran, and 2-methyltetrahydrofuran; alcohols, such as methanol, ethanol, ethylene glycol monoalkyl ethers, propylene glycol monoalkyl ethers, polyethylene glycol monoalkyl ethers, polypropylene glycol monoalkyl ethers, ethylene glycol, propylene glycol, polyethylene glycol, polypropylene glycol, and glycerin; carbonates, such as dimethyl carbonate, diethyl carbonate, methyl ethyl carbonate, ethylene carbonate, and propylene carbonate; ester compounds, such as methyl acetate, methyl propionate, and butyrolactone; nitrile compounds, such as acetonitrile, methoxyacetonitrile, propionitrile, benzonitrile, and glutarodinitrile; heterocyclic compounds, such as 3-methyl-2-oxazolidinone and 2-methylpyrrolidone; aprotic polar substances, such as dimethyl sulfoxide, sulfolane, and dimethylformamide; and water. These solvents may be used singly or two or more of them may be used in combination.

Furthermore, a basic compound such as tert-butylpyridine, 2-picoline or 2,6-lutidine is preferably added to the electrolysis solution. The concentration of such a basic compound is preferably 0.1 to 1.0 mol/L.

The so-called gel electrolyte, which comprises a polymer matrix impregnated with the above-mentioned electrolysis solution, or a molten salt having a oxidation-reduction pair may be used as the charge transfer layer. The gel electrolyte-containing polymer matrix or the above molten salt may be any of those known in the art. From the viewpoint of improvements in the cell performance of the dye-sensitized solar cell, the use of an electrolysis solution is preferred.

When an electrolysis solution is used as the charge transfer layer, the electrolysis solution is preferably filled in a porous support. The use of a porous support makes it possible to prevent the electrolysis solution from leaking out.

Usable as the porous support are filters for filtration (membrane filters), separators known in the art for use in conventional primary and secondary cells, and nonwoven fabrics, among others. The porous support must have through holes (voids) so that the electrolyte in the electrolysis solution can pass therethrough. That the through holes (voids) go through the porous support in the direction perpendicular thereto is preferred from the viewpoint of improvements in the cell performance of the dye-sensitized solar cell. This is because when the support has such through holes (voids), the factor inhibiting the migration of the electrolyte is reduced.

Preferred as the material of the above filters for filtration are polyolefins such as polyethylene and polypropylene; polyesters such as polyethylene terephthalate; and glass fibers.

Suited for use as the material of the separators used in ordinary primary or secondary cells or of the nonwoven fabrics are polyolefins such as polyethylene and polypropylene; polyesters such as polyethylene terephthalate; polyamides; polyimides; acetalized polyvinyl alcohol (vinylon); vinyl chloride-vinyl acetate copolymers; and polyphenylene sulfide. These separators or nonwoven fabrics may be made of a single material or may be used in the form of composites obtained ,for example, by sticking together two or more separators or nonwoven fabrics made of different materials. Each may also be a separator or nonwoven fabric made of two or more materials (e.g. nonwoven fabric composed of melt blend spun fibers).

For preventing the leakage of the electrolysis solution in the dye-sensitized solar cell, it is preferred that there be no gaps between the semiconductor electrode and porous support or between the porous support and reference electrode. Thus, the thickness of the porous support, though not particularly restricted, is preferably the same as the distance between the semiconductor electrode and reference electrode, hence, generally, it is 0.1 to 50 $\mu$m. In particular, when the thickness of the porous support exceeds the above range, the distance of migration of the electrolyte becomes long and, therefore, the cell performance tend to lower.

The proportion of the void of above porous support is preferably 70 to 90%. When the porous support has such proportion of the void, it can prevent the electrolyte from leaking out and, at the same time, it will not inhibit the transfer of the electrolyte in a dye-sensitized solar cell to the extent of reducing the energy conversion efficiency.

[Other constituent elements and structure of the dye-sensitized solar cell]

In the dye-sensitized solar cell of the present invention, the semiconductor electrode and/or reference electrode may be provided, on the surface opposite to the charge transfer layer, with a protective layer (s) (e.g. ultraviolet barrier layer, waterproof/moistureproof layer), an antireflective layer, a photocatalyst layer and/or a like functionality providing layer. These functionality providing layers each to be used may be any of those known in the art.

For preventing short-circuiting between the semiconductor electrode and reference electrode, it is also preferable to provide a dense or compact semiconductor foundation layer between the conductive substrate and semiconductive layer of the semiconductor electrode. Suitable materials for the foundation layer are $TiO_2$, $Fe_2O_3$, ZnO, $Nb_2O_5$, $SnO_2$, and $WO_3$. The foundation layer can be formed in the conventional manner, for example by spray pyrolysis. The foundation layer generally has a thickness of 5 to 1,000 nm, more generally 10 to 500 nm.

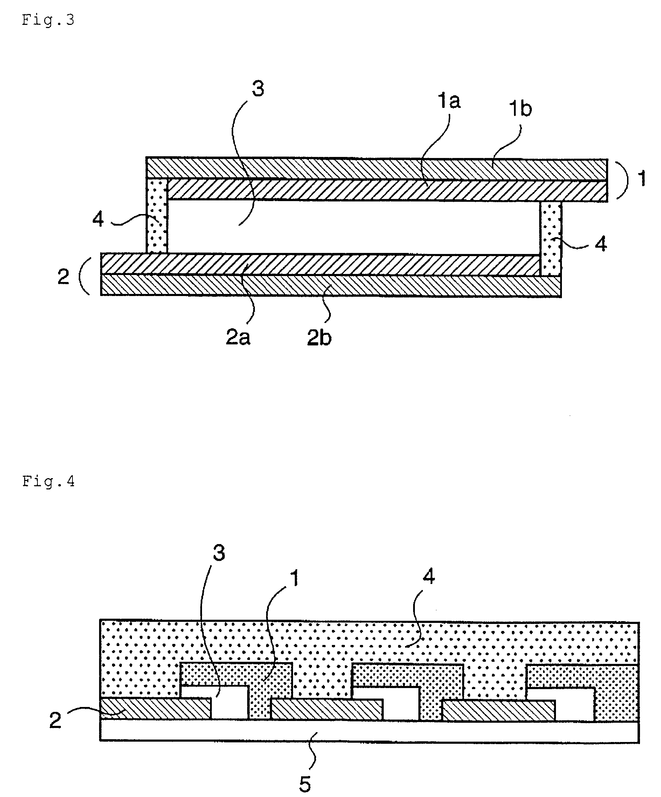

The structure of the dye-sensitized solar cell of the present invention is now described. A typical example of the dye-sensitized solar cell is shown in Fig. 3. In this example, the cell has a structure such that the conductive layer 1a of the reference electrode 1 is face to face with the semiconductor layer 2a of the semiconductor electrode 2, with the charge transfer layer 3 sandwiched between the reference electrode 1 and semiconductor electrode 2. The charge transfer layer 3 may be a porous support impregnated with an electrolysis solution, as mentioned hereinabove. For preventing the leakage of the charge transfer layer 3 and maintaining the shape of the dye-sensitized solar cell, all faces other than the faces formed by the reference electrode 1 and semiconductor electrode 2 are sealed using a sealant 4.

The above sealant or sealing material can appropriately be selected from among those materials known in the art according to the charge transfer layer material species and other factors. For example, epoxy resins and ionomer resins may be mentioned as typical materials. The strength of the sealant can be increased by filling such sealant with a transparent filler. The sealant can be formed in the known manner, for example by closely sticking, with heating, an epoxy resin film to the peripheral edges of the electrodes.

Glass may also be effectively used as the sealant. In this case, glass sheets or glass beads, for instance, are adhered to the peripheral edges of the reference electrode and semiconductor electrode using an epoxy resin adhesive, for instance.

Use may also be made of the method comprising applying a glass frit paste to the peripheral edges of the reference electrode and semiconductor electrode, followed, for example, by sintering to form a glass sealant. In this case, no organic adhesive is used and, therefore, the degeneration of the adhesive, which occurs during the use of the dye-sensitized solar cell and produces a bad influence, can be avoided among others.

When this method is employed, a close unit is produced using the reference electrode, the semiconductor electrode before adsorption of the sensitizing dye, and the above-mentioned glass frit paste and, then, the steps of adsorption of the sensitizing dye and injection of the electrolysis solution and the like for charge transfer layer formation are carried out so that the degeneration of the sensitizing dye and/or charge transfer layer upon sintering can be avoided. In preparing the above closed unit, at least one opening is formed for the injection of the sensitizing dye solution and of the electrolysis solution for charge transfer layer formation. The opening can be formed, for example, by inserting a glass tube or the like into a glass frit paste portion before sintering and then carrying out sintering. The adsorption of the sensitizing dye onto the semiconductor electrode can be effected, for example, by circulating the sensitizing dye solution through the above-mentioned opening. After completion of the sensitizing dye adsorption treatment and the subsequent complete removal of the sensitizing dye solution, the electrolysis solution for charge transfer layer formation is poured into the unit or cell through the above opening.

Any of the glass frit pastes known in the art can be employed as the above-mentioned paste. More specifically, a paste prepared by mixing a glass powder with a binder resin (e.g. acrylic resin) is preferably used. The glass powder can appropriately be selected from among the known glass powders.

It is also preferable to dispose spacers between the reference electrode 1 and semiconductor electrode 2 for the purpose of correcting the distortion of these electrodes and/or preventing short-circuiting between these electrodes. Suited as the material of such spacers are polyolefins such as polyethylene and polypropylene; polyesters such as polyethylene terephthalate; polyamides; polyimides; acetalized polyvinyl alcohol (vinylon); vinyl chloride-vinyl acetate copolymers; and polyphenylene sulfide. The preferred spacer thickness is the same as that mentioned hereinabove for the porous support.

The dye-sensitized solar cell of the present invention may have a structure comprising one reference electrode-semiconductor electrode pair, as shown in Fig. 3, or a module structure having two or more of reference electrode-semiconductor electrode pairs. In the case of such module structure, it becomes possible to secure a greater quantity of electricity.

When the dye-sensitized solar cell of the present invention is given a module structure, any of the module structures known in the art may be employed. An example of the module structure of the dye-sensitized solar cell of the present invention is shown in Fig. 4. When a module structure is employed, two or more of sets of reference electrode 1-charge transfer layer 3-semiconductor electrode 2 are generally disposed on a substrate 5, as shown in Fig. 4, and the whole is covered on the top with a sealant 4.

When the above substrate 5 is a nontransparent material, such as an ordinary metal sheet, the cell is irradiated with light from the sealant 4 side, so that the sealant 4 must be transparent. On the other hand, when a transparent material (e.g. reinforced glass) is used as the substrate 5, the cell can be irradiated with light from the substrate 5 side, so that the sealant 4 need not be transparent; of course, it may be transparent. When a transparent material is employed as only one of the sealant 4 and substrate 5, at least one of the reference electrode 1 and the conductive substrate 2b of the semiconductor electrode 2, on the side from which light irradiation is possible, must be transparent. The term "transparent" as used herein has the same meaning as the term "substantially transparent" as used hereinabove referring to the reference electrode.

Fig. 3 and Fig. 4 illustrating the structure of the dye-sensitized solar cell of the present invention are given only to show typical examples and have no restrictive meaning.

The dye-sensitized solar cell of the present invention, when it is connected to an external circuit, is ready for use. The external circuit may be any of those known in the art, for example a known secondary cell or battery. Such external circuit is connected to the reference electrode and semiconductor electrode of the dye-sensitized solar cell by means of leads, for instance.

BRIEF DESCRIPTION OF THE DRAWING

Fig. 1 is a cyclic voltammogram obtained by CV measurement using a Pt electrode.
Fig. 2 is a cyclic voltammogram obtained by CV measurement using a glassy carbon electrode.
Fig. 3 is a schematic cross-sectional view illustrating the structure of a dye-sensitized solar cell constituted of a reference electrode-charge transfer layer-semiconductor electrode set.
Fig. 4 is schematic cross-sectional view illustrating the structure of a dye-sensitized solar cell constituted of two or more of reference electrode-charge transfer layer-semiconductor electrode sets.

Explanation of Symbols

| 1 | reference electrode |
|---|---|
| 1a | conductive layer |
| 2 | semiconductor electrode |
| 2a | semiconductor layer |
| 2b | conductive substrate |
| 3 | charge transfer layer |
| 4 | sealant |
| 1b, 5 | substrate |

The dye-sensitized solar cell of the present invention has the above-mentioned constitution and can exhibit high-level cell performance. In addition, the cost of production thereof can be reduced.

BEST MODE FOR CARRYING OUT THE INVENTION

The following examples illustrate the present invention in detail. However, the following examples are by no means limitative of the scope of the present invention. It should be noted that all changes or modifications made without departing the spirits of the foregoing and subsequent descriptions fall within the scope of the present invention.

Comparative Example 1 (Dye-sensitized solar cell in which a Pt electrode is used as the reference electrode)

A dye-sensitized solar cell having the following constitution was produced.

(Reference electrode)

A Pt sheet was used as the reference electrode. This Pt sheet reference electrode had a roughness factor of 1.

(Semiconductor electrode)

An FTO substrate (product of Nippon Sheet Glass Co.,Ltd., trademark "VZ019", tin oxide-coated glass) was spin-coated with a titania sol (product of Ishihara Sangyo Co.,Ltd., trademark "STS-21"). After drying at 100°C, this was further subjected to 1 hour of heat treatment at 450°C to give a porous $TiO_2$ thin film electrode (semiconductor electrode). This electrode was immersed in an ethanol solution of the RuN3 dye (concentration $3.0 \times 10^{-3}$ mol/L) for 10 hours to give a semiconductor electrode with the RuN3 dye (sensitizing dye) adsorbed thereon. The RuN3 dye is a product of Solaronix corp., "Ruthenium 535" (trademark), [Cis-bi(isothiocyanato)bis(2,2'-bipyridyl-4,4'-dicarboxylato)ruthenium (II)].

The semiconductor layer (thin porous $TiO_2$ layer) of the semiconductor electrode had a thickness of 2 $\mu$m. The semiconductor electrode prior to sensitizing dye adsorption had a roughness factor of 300 as determined by dividing the specific surface area of the semiconductor electrode as measured by the BET adsorption method (gas adsorbed: $N_2$) using the Delsorp corp. apparatus by the sum total of the areas of the respective surfaces of the semiconductor electrode as projected from just above.

(Charge transfer layer)

An electrolysis solution was used which was composed of the solvent: acetonitrile and the electrolytes: lithium iodide (concentration 0.1 mol/L), iodine (concentration 0.05 mol/L), 1,2-dimethyl-3-propylimidazole iodide (concentration 0.3 mol/L) and tert-butylpyridine (concentration 0.5 mol/L).

The above reference electrode, semiconductor electrode and charge transfer layer were disposed as shown in Fig. 3 and sealed up with a sealant (product of Mitsui Dupont Fluorochemicals Co.,Ltd., trademark "Himilan") to give a dye-sensitized solar cell No. 1. The distance between the reference electrode and semiconductor electrode was 20 $\mu$m. The electrode area was 0.2 $cm^2$ (4 x 5 mm).

The above reference electrode (Pt sheet electrode) was subjected to CV measurement according to the method mentioned hereinabove. Used for the CV measurement were a Hokuto Denko Corp. model "HA-151" potentiostat and a Hokuto Denko Corp. model "HB-111" function generator.

A cell performance measurement of the dye-sensitized solar cell No. 1 was carried out in the following manner.

The reference electrode and semiconductor electrode of the dye-sensitized solar cell No. 1 were connected to a current-voltage measuring apparatus constituted of an ammeter (product of KEITHLEY Corp., trademark "487"), a function generator (product of Hokuto Denko Corp., trademark "HB-105") and a potentiostat (product of Hokuto Denko Corp., trademark "HA-5016") using lead wires having an alligator clip. Then, the dye-sensitized solar cell No. 1 was irradiated, on the semiconductor electrode substrate side, with simulated sunlight (light intensity I: 100 mW/cm$^2$) obtained by passing light from a 500 W xenon lamp (product of Ushio Co.,Ltd) through a spectroscopic filter (product of Oriel Corp., trademark "AM1.5"). The electricity generated on that occasion by the dye-sensitized solar cell No. 1 was measured using the above current-voltage measuring apparatus. From the results obtained, the open circuit photo-voltage Voc, short circuit photo-current density Jsc and fill factor FF were determined and the energy conversion efficiency η was calculated according to the formula (1) given hereinabove.

The cyclic voltammogram obtained by the CV measurement with the reference electrode is shown in Fig. 1. The relation between the oxidation-reduction current value differences a and b determined from this cyclic voltammogram was b < a. The half-wave potentials, which is oxidation-reduction potentials observed on the negative side (on the above-mentioned ferrocene standard basis) in Fig. 1, for I$^-$/I$_3^-$ were -0.15 V and +0.24 V. The open circuit photo-voltage obtained by the cell performance measurement of the dye-sensitized solar cell No. 1 was 0.70 V.

Example 1

A dye-sensitized solar cell (No. 2) having the same constitution as the dye-sensitized solar cell No. 1 was produced except that the reference electrode (activated carbon electrode) mentioned below was used as the reference electrode.

(Reference electrode)

100 g of powdery activated carbon (product of Kanebo, Ltd. "APF-10", specific surface area 1,000 m$^2$/g, average particle size 20 μm), 5 g of carbon black (product of Denki Kagaku Kogyo Kabushiki Kaisha, trademark "Denka Black" granular, specific surface area 92 m$^2$/g, average particle size 35 nm) and 10 g of carboxymethylcellulose (product of Daicel Chemical Industries, Ltd, trademark "DN-400H") were mixed up by the dry process using an automatic mortar. This mixed powder was dispersed in 1,000 mL of pure water and a slurry was obtained. The thus-obtained slurry for reference electrode formation was applied to an FTO substrate (product of Nippon Sheet Glass Co.,Ltd., trademark "VZ019") by the doctor blade method, followed by 30 minutes of drying at 160°C to give a reference electrode.

The activated carbon layer of the reference electrode obtained had a thickness of 100 μm. The roughness factor of the reference electrode as determined by the same method as for the semiconductor electrode of the dye-sensitized solar cell No. 1 was 12,000.

The dye-sensitized solar cell No. 2 was subjected to cell performance measurement in the same manner as in Comparative Example 1. The open circuit photo-voltage obtained in the cell performance measurement of the dye-sensitized solar cell was 0.75 V. Further, when the energy conversion efficiency obtained with the dye-sensitized solar cell No. 1 (Comparative Example 1) was taken as 100, the energy conversion efficiency of the dye-sensitized solar cell No. 2 was 110.

Example 2

A dye-sensitized solar cell No. 3 having the same constitution as the dye-sensitized solar cell No. 1 was produced except that the reference electrode (glassy carbon electrode) mentioned below was used.

(Reference electrode)

A reference electrode (glassy carbon electrode) was produced in the same manner as in Example 1 except that a glassy carbon powder (product of Kanebo, Ltd., trademark "C-2000", average particle size 15 μm) was used instead of the powdery activated carbon. The roughness factor of the reference electrode as determined by the same method as used for the semiconductor electrode of the dye-sensitized solar cell No. 1 was 100.

The CV measurement by the reference electrode and the cell performance measurement of the dye-sensitized solar cell No. 3 were carried out in the same manner as in Comparative Example 1.

The cyclic voltammogram obtained by the CV measurement with the reference electrode is shown in Fig. 2. The relation between the oxidation-reduction current value differences a and b determined from this cyclic voltammogram was b > a. The half-wave potentials, which is oxidation-reduction potentials observed on the negative side (on the above-mentioned ferrocene standard basis) in Fig. 1, for I$^-$/I$_3^-$ were -0.09 V and +0.31 V. The open circuit photo-voltage obtained by the cell performance measurement of the dye-sensitized solar cell No. 3 was 0.75 V.

Example 3

A dye-sensitized solar cell No. 4 having the same constitution as the dye-sensitized solar cell No. 1 was produced except that the reference electrode (graphite electrode) mentioned below was used.

(Reference electrode)

A reference electrode (graphite electrode) was produced in the same manner as in Example 1 except that a graphite powder (product of SCE Corp., trademark "SGP-15", average particle size 15 μm) was used instead of the powdery activated carbon.

The graphite layer of the reference electrode obtained had a thickness of 100 μm. The roughness factor of the reference electrode as determined by the same method as used for the semiconductor electrode of the dye-sensitized solar cell No. 1 was 1,000.

The dye-sensitized solar cell No. 4 was subjected to cell performance measurement in the same manner as in Comparative Example 1. When the energy conversion efficiency obtained with the dye-sensitized solar cell No. 1 (Comparative Example 1) was taken as 100, the energy conversion efficiency of the dye-sensitized solar cell No. 4 was 40.

Example 4

100 g of powdery activated carbon (product of Kanebo, Ltd., trademark "Bell fine AP-15", specific surface area 1,500 m$^2$/g, average particle size 10 μm), 20 g of carbon black (product of Denki Kagaku Kogyo Kabushiki Kaisha, trademark "Denka Black" granular, specific surface area 92 m$^2$/g, average particle size 35 nm) and 12 g of carboxymethylcellulose (product of Daicel Chemical Industries, Ltd., trademark "DN-400H") were mixed up by the dry process using an automatic mortar. This mixed powder was dispersed in a mixed solvent composed of 800 mL of pure water and 400 mL of ethanol and a slurry for reference electrode was obtained. The thus-obtained slurry for reference electrode formation was applied to an FTO substrate (product of Nippon Sheet Glass Co.,Ltd., trademark "VZ019") by the doctor blade method, followed by 60 minutes of drying at 200°C to give a reference electrode.

The activated carbon layer of the reference electrode obtained had a thickness of 25 μm. The roughness factor of the reference electrode as determined by the same method as for the semiconductor electrode of the dye-sensitized solar cell No. 1 was 6,000.

A dye-sensitized solar cell No. 5 having the same constitution as the dye-sensitized solar cell No. 1 was produced. The cell performance measurement of the dye-sensitized solar cell No. 5 was carried out in the same manner as in Comparative Example 1.

The open circuit photo-voltage obtained by the cell performance measurement of the dye-sensitized solar cell No. 5 was 0.75 V. Further, when the energy conversion efficiency obtained with the dye-sensitized solar cell No. 1 (Comparative Example 1) was taken as 100, the energy conversion efficiency of the dye-sensitized solar cell No. 5 was 105.

Example 5

100 g of powdery activated carbon (product of Kanebo, Ltd., trademark "Bell fine AP-20", specific surface area 2,000 m$^2$/g, average particle size 10 μm), 20 g of carbon black (product of Denki Kagaku Kogyo Kabushiki Kaisha, trademark "Denka Black" granular, specific surface area 92 m$^2$/g, average particle size 35 nm) and 12 g of carboxymethylcellulose (product of Daicel Chemical Industries, Ltd., trademark "DN-400H") were mixed up by the dry process using an automatic mortar. This mixed powder was dispersed in a mixed solvent composed of 800 mL of pure water and 400 mL of ethanol and a slurry for reference electrode was obtained. The thus-obtained slurry for reference electrode formation was applied to an FTO substrate (product of Nippon Sheet Glass Co.,Ltd., trademark "VZ019") by the doctor blade method, followed by 60 minutes of drying at 200°C to give a reference electrode.

The activated carbon layer of the reference electrode obtained had a thickness of 25 μm. The roughness factor of the reference electrode as determined by the same method as for the semiconductor electrode of the dye-sensitized solar cell No. 1 was 19,000.

A dye-sensitized solar cell No. 6 having the same constitution as the dye-sensitized solar cell No. 1 was produced. The cell performance measurement of the dye-sensitized solar cell No. 6 was carried out in the same manner as in Comparative Example 1.

The open circuit photo-voltage obtained by the cell performance measurement of the dye-sensitized solar cell No. 6 was 0.75 V. Further, when the energy conversion efficiency obtained with the dye-sensitized solar cell No. 1 (Comparative Example 1) was taken as 100, the energy conversion efficiency of the dye-sensitized solar cell No. 6 was 120.

The present application claims priority under 35 U.S.C. §119 to Japanese Patent Application No. 2002-20241, filed January 29, 2002, entitled "PIGMENT-SENSITIZED SOLAR CELL" and Japanese Patent Application No.2002-331076, filed November 14, 2002, entitled "PIGMENT-SENSITIZED SOLAR CELL". The contents of these applications are incorporated herein by reference in their entirety.

**Claims**

1. A dye-sensitized solar cell comprising, as constituent elements, a semiconductor electrode with a sensitizing dye adsorbed thereon, a charge transfer layer and a reference electrode,
   said reference electrode satisfies the relation b > a, where a (mA) denotes the oxidation-reduction electric current value difference in a negative potential region of not lower than -0.7 V but lower than 0 V and b (mA) denotes the oxidation-reduction electric current value difference measured in a positive potential region of 0 V to 0.7 V,

said oxidation-reduction electric current value difference are measured by cyclic voltammetry with the oxidation-reduction potential of ferrocene as a standard.

2. A dye-sensitized solar cell comprising, as constituent elements, a semiconductor electrode with a sensitizing dye adsorbed thereon, a charge transfer layer and a reference electrode,

wherein said reference electrode has a roughness factor of not less than 5,000.

3. The dye-sensitized solar cell according to Claim 1,

wherein the reference electrode has a roughness factor of not less than 5,000.

4. The dye-sensitized solar cell according to Claim 1, 2 or 3,

wherein the reference electrode comprises a carbonaceous material as a constituent material thereof.

5. The dye-sensitized solar cell according to Claim 4,

wherein the reference electrode further comprises a binder as a constituent material thereof.

6. The dye-sensitized solar cell according to Claim 4 or 5,

wherein the reference electrode further comprises an electric conductivity providing agent as a constituent material thereof.

7. A dye-sensitized solar cell comprising, as constituent elements, a semiconductor electrode with a sensitizing dye adsorbed thereon, a charge transfer layer and a reference electrode,

wherein said reference electrode comprises activated carbon as a constituent material thereof.

8. A dye-sensitized solar cell comprising, as constituent elements, a semiconductor electrode with a sensitizing dye adsorbed thereon, a charge transfer layer and a reference electrode,

wherein said reference electrode comprises, as a constituent material thereof, a material having a specific surface area of not less than 500 $m^2$/g.

Fig.1

Fig.2

Fig.3

Fig.4